(19) Europäisches Patentamt

European Patent Office

Office européen des brevets

(11) **EP 0 877 488 B1**

(12) **EUROPÄISCHE PATENTSCHRIFT**

(45) Veröffentlichungstag und Bekanntmachung des Hinweises auf die Patenterteilung:
**04.09.2002   Patentblatt 2002/36**

(51) Int Cl.⁷: **H03M 1/00**, G01D 5/14

(21) Anmeldenummer: **98106206.0**

(22) Anmeldetag: **04.04.1998**

(54) **Verfahren zum Messen des Drehwinkels einer drehbaren Welle, insbesondere eines drehbaren Schalters und Vorrichtung zur Ausführung des Verfahrens**

Method for detecting the angle of rotation of a rotatable shaft, in particular of a rotatable switch, and device for carrying out the method

Procédé pour mesurer l'angle de rotation d'un arbre rotatif, en particulier d'un commutateur rotatif, et dispositif pour la mise en oeuvre du procédé

(84) Benannte Vertragsstaaten:
**DE FR GB**

(30) Priorität: **09.05.1997   DE 19719564**

(43) Veröffentlichungstag der Anmeldung:
**11.11.1998   Patentblatt 1998/46**

(73) Patentinhaber: **Siemens Aktiengesellschaft**
**80333 München (DE)**

(72) Erfinder: **Jäger, Wolfgang**
**36381 Schlüchtern (DE)**

(56) Entgegenhaltungen:
**FR-A- 2 221 876**

EP 0 877 488 B1

**Beschreibung**

Die Erfindung betrifft ein Verfahren zum Messen des Drehwinkels einer drehbaren Welle, bei dem zwei sinusförmige, gegeneinander phasenverschobene Signale erzeugt werden und aus den gemessenen Werten der Signale auf den Drehwinkel geschlossen wird, wobei die sinusförmigen Signale vor der ersten Messung normiert werden und eine Vorrichtung zur Ausführung des Verfahrens. Die sinusförmigen Signale sind Schwankungen in der Amplitude unterworfen, die z.B. durch die Alterung oder durch den Temperaturgang der verwendeten Bauteile hervorgerufen werden. Deshalb wird bei bekannten Verfahren, die aus den Meßwerten über Arcussinus- und Arcuscosinusfunktionen auf den gemessenen Drehwinkel schließen, die Normierung auch während der laufenden Messungen wiederholt. Dies erfolgt z.B. durch das Messen eines Extremwertes für das eine Signal, wenn für das andere Signal ein Nulldurchgang ermittelt wird. Die Arcussinus- und Arcuscosinusfunktionen und die zusätzlichen Normierungen erfordern jeweils aufwendige, komplexe und damit auch zeitaufwendige Rechnungen.

Aus der FR-A 2 221 876 ist weiterhin eine Einrichtung zur Bestimmung eines Drehwinkels bekannt. Diese Einrichtung weist mehrere logische Gatter und einen Codierer auf. Der Codierer bildet den Quotienten aus dem Sinus und der Summe oder der Differenz des Sinus und Kosinus des jeweils gesuchten Winkels. Hieraus wird dann der gesuchte Winkel in einer Annäherung abgeleitet.

Aufgabe der Erfindung ist es, ein Verfahren und eine Vorrichtung zur Ausführung des Verfahrens anzugeben, die nur einfache Rechnungen erfordern. Diese Aufgabe wird dadurch erreicht, daß die Signale, die größer als der normierte Maximal- oder kleiner als der normierte Minimalwert sind, auf den Maximal- bzw. Minimalwert begrenzt werden. Weiterhin wird aus dem Wert der beiden gemessenen Signale der Quadrant bestimmt, in dem sich der gesuchte Winkel befindet. In Abhängigkeit des Vorzeichens der jeweiligen Kurvensteigung wird das Vorzeichen des gemessenen Signalwertes verändert oder beibehalten. So kann entweder bei positiver Steigung der jeweiligen Kurve das Vorzeichen des zugehörigen Signalwertes beibehalten werden und bei negativer Steigung der jeweiligen Kurve das Vorzeichen des Signalwertes geändert werden (erste Alternative), oder aber bei positiver Steigung der jeweiligen Kurve das Vorzeichen der jeweiligen Signalwerte geändert werden und bei negativer Steigung der jeweiligen Kurve das Vorzeichen des Signalwertes beibehalten werden (zweite Alternative). Die so erhaltenen Signalwerte werden addiert und man erhält eine erste Summe S. Diese erste Summe S entspricht der Winkeldifferenz β zwischen der Mitte des ermittelten Quadranten und dem gemessenen Winkel, wobei der Wert der Amplitudendifferenz AD zwischen den normierten Maximal- und Minimalamplituden einem Winkel von 90° entspricht, es gilt also:

$$\beta = \frac{S}{AD} \times 90° \qquad\qquad \text{(Gleichung 1)}$$

Dieses Verfahren hat den Vorteil, daß auf Normierungen während der Messungen verzichtet werden kann.

Addiert man zu der so erhaltenen ersten Summe S den halben Wert der Amplitudendifferenz AD zwischen der normierten maximalen und minimalen Amplitude, so erhält man eine zweite Summe. Diese zweite Summe gibt den Anteil des gemessenen Drehwinkels an einer vollständigen Drehung um 90° innerhalb des bestimmten Quadranten an, wobei der Wert einer vollständigen Drehung um 90° ebenfalls dem Wert der Amplitudendifferenz zwischen der normierten Maximal- und Minimalamplitude entspricht.

Der Differenzwinkel β läßt sich auch grafisch ablesen an einer dritten Kurve. Wenn bei einer negativen Steigung der jeweiligen sinusförmigen Kurve das Vorzeichen des gemessenen Wertes verändert wurde, weist die dritte Kurve zu Beginn eines jeden Quadranten den halben negativen Wert der Amplitudendifferenz zwischen der normierten Maximal- und Minimalamplitude, in der Mitte des Quadranten den Wert 0 und am Ende des jeweiligen Quadranten den halben positiven Wert der Amplitudendifferenz zwischen der normierten Maximal- und Minimalamplitude auf. Ist die Kurve innerhalb eines Quadranten jeweils geradenförmig, stimmen die abgelesenen Werte mit dem nach Gleichung 1 erhaltenen Wert überein. Aufwendiger, aber genauer ist die dritte Kurve, wenn man für eine Anzahl von Winkeln die Summen der dem jeweiligen Winkel entsprechenden Sinus- und Cosinuswerte zuordnet, deren Vorzeichen bei einer fallenden Signalkurve verändert wurden. Nachteilig hierbei ist aber, daß die Funktionswerte neu berechnet werden oder in einem Speicher abgelegt werden müssen und dann mit der aus den Meßwerten erhaltenen ersten Summe verglichen werden müssen. Der systembedingte Fehler, der durch die Verwendung von Gleichung 1 auftritt, liegt unter 1% einer vollständigen Umdrehung und ist in den meisten Anwendungsfällen akzeptabel, wenn die Amplituden die normierte Amplitude um bestimmte Werte nicht über- oder unterschreiten.

Anstatt einer dritten Kurve kann man auch eine Winkeltabelle anlegen, wobei die Summen der jeweiligen Sinus- und Cosinuswerte der Winkel den entsprechenden Winkeln zugeordnet werden, wobei die Vorzeichen der jeweiligen Werte entsprechend Schritt c) angepaßt sind. Die Summen nehmen in jedem Quadranten Werte zwischen -1 und +1 ein, wobei jedem Wert innerhalb eines Quadranten ein bestimmter Winkelwert zugeordnet werden kann. Sofern ein gemessener Wert zwischen zwei Werten der Tabelle liegt, kann der gemessene Wert entsprechend gemittelt werden.

Eine vierte Kurve, die sich von 0 bis zum vierfachen Wert der Amplitudendifferenz AD zwischen dem normierten Maximal- und Minimalamplitude erstreckt, ordnet jedem Winkel innerhalb der vier Quadranten einen bestimmten Wert zu, so daß mit dem bestimmten Wert der Winkel in der vierten Kurve abgelesen werden kann. Hierzu müssen zu der errechneten ersten Summe der beiden Meßwerte in jedem Quadranten jeweils so viele Werte der Amplitudendifferenz AD hinzuaddiert werden, wie benötigt werden, um die dritte Kurve von ihrer Position zwischen dem negativen halben Wert der Amplitudendifferenz AD und dem halben Wert der Amplitudendifferenz AD in jedem Quadranten auf die entsprechende Position in dem jeweiligen Quadranten zu verschieben.

Bei geschickter Unterteilung der Normierung erhält man durch Addition der Summe der beiden Meßwerte und dem Korrekturwert für den jeweiligen Quadranten durch einfache Addition bzw. Subtraktion den gewünschten Winkel in einem bestimmten Verhältnis zur vollständigen Umdrehung. Bei Unterteilung der Amplitudendifferenz zwischen der maximal- und minimal normierten Amplitude in 90 gleiche Teile gibt die erste Summe den Abstand des gesuchten Winkels in Grad von der Mitte des ermittelten Quadranten, an.

Eine erfindungsgemäße Vorrichtung zur Ausführung des Verfahrens weist eine Einrichtung auf, die durch Drehung ein sinusförmiges Signal erzeugt und die mit der Welle verbunden ist, deren Drehwinkel bestimmt werden soll, insbesondere einen drehbaren Schalter. Weiterhin weist die Vorrichtung zwei Sensoren auf, die in gleichem Abstand von der Drehachse der Welle so angeordnet sind, daß sie das von der Einrichtung ausgesandte Signal erfassen können, wobei die Sensoren so angeordnet sind, daß die von ihnen aufgenommenen Signale um 90°-phasen-verschoben sind. Schließlich weist die Vorrichtung eine Auswerteeinrichtung auf, die aus den aufgenommenen Signalen den Winkel mit dem erfindungsgemäßen Verfahren berechnet. Die Einrichtung, die ein sinusförmiges Signal erzeugt, besteht vorteilhafterweise aus einem Magneten der um seine Mittelsenkrechte drehbar gelagert ist. Die Sensoren sind dann vorteilhafterweise als Hallsensoren oder Spulen ausgebildet. Ein besonders einfacher Schaltungsaufbau läßt sich durch Verwendung von selbstjustierenden Hallsensoren verwirklichen.

Die Erfindung wird nachfolgend anhand der Figuren näher beschrieben. Es zeigen:

Figur 1     den Schnitt durch einen drehbaren Schalter, in dem das erfindungsgemäße Verfahren zur Bestimmung des Drehwinkels eingesetzt werden kann

Figur 2     den Verlauf von zwei phasenverschobenen Signalen

Figur 3     den Verlauf der zwei Signale aus Figur 2 nach ihrer Normierung

Figur 4     Die normierten Signale aus Figur 3 und eine dritte Kurve

Figur 5     Den Verlauf einer vierten Kurve und den Verlauf des sich aus Gleichung 1 ergebenen Systemfehlers

Figur 6     Den erfindungsgemäßen normierten Verlauf für Signale, deren Maximalamplitude der 1,2 fachen normierten Amplitude entspricht

Figur 7     Den Signalverlauf aus Figur 6, die vierte Kurve aus Figur 5 und den Fehler, der dadurch entsteht, daß die Spitzen der Kennlinie aus Figur 6 abgeschnitten wurde

Figur 8     Zwei Kurven, die nur die 0,8 fachen normierte Amplitude erreichen und den dabei durch das erfindungsgemäße Verfahren auftretenden Fehler, bei Verwendung von Gleichung 1

Figur 9     Den schematischen Aufbau einer erfindungsgemäßen Vorrichtung zur Ausführung des erfindungsgemäßen Verfahrens

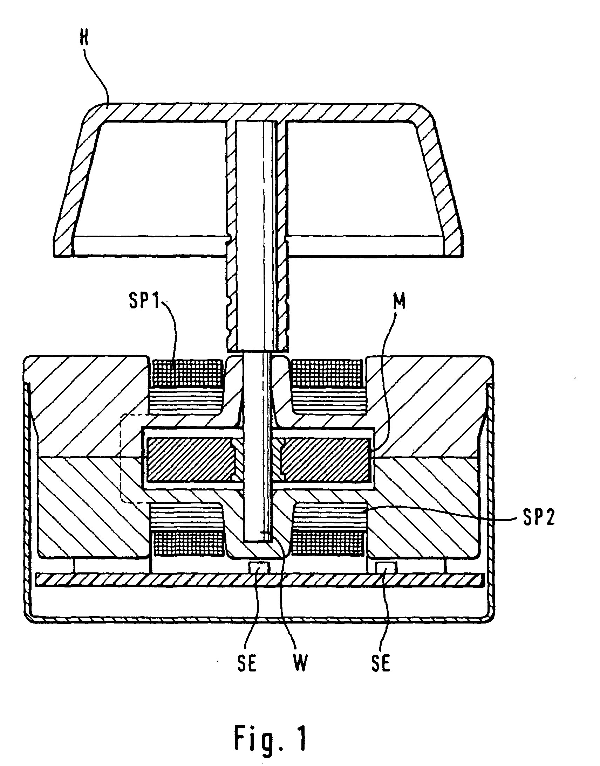

Figur 1 zeigt einen drehbaren Schalter, bei dem über eine Handhabe H eine Welle W mit einer diametral magnetisierten Scheibe M drehbar gelagert ist. Die diametral magnetisierte Scheibe M erzeugt in den Hallsensoren SE Spannungen, aus deren Werten mit dem erfindungsgemäßen Verfahren der Drehwinkel der Welle W berechnet werden kann.
Zwei Spulen SP1, SP2 sind so angeordnet, daß sie bei entsprechender Bestromung im Zusammenwirken mit der diametral magnetisierten Scheibe M ein Drehmoment erzeugen, das der Bediener des Schalters über die Handhabe H wahrnehmen kann.

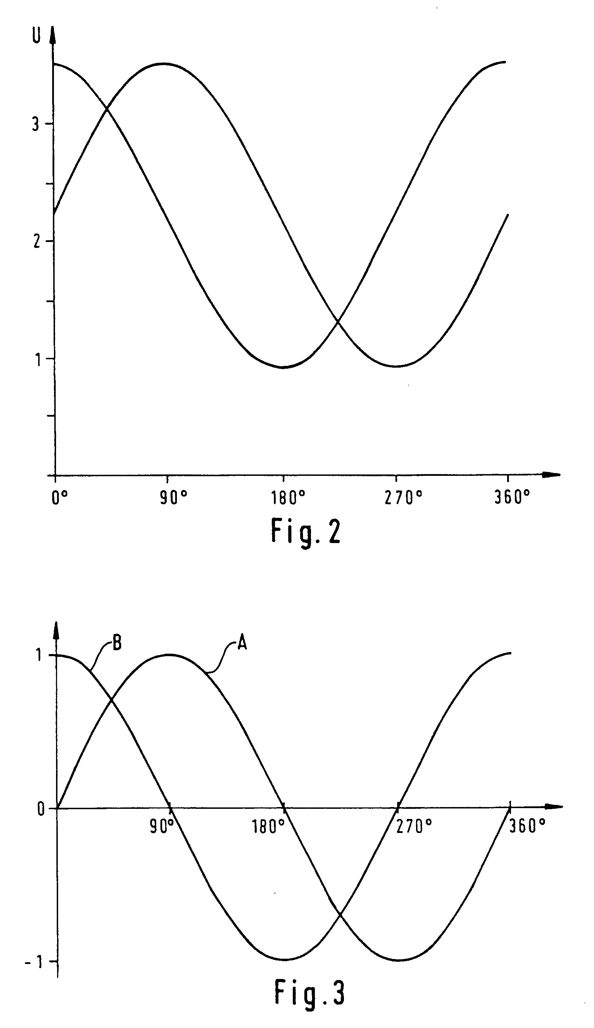

Figur 2 zeigt die Spannungen, die beispielsweise zwei Hallsensoren liefern, während einer Drehung einer diametral magnetisierten Scheibe um 360°, die mit der Welle verbunden ist, deren Drehwinkel bestimmt werden soll. Diese Spannungen werden verstärkt und mit einem Offset versehen. Dies geschieht vorteilhafterweise bereits in den heute zur Verfügung stehenden Hallsensoren. Die Hallsensoren verfügen vorteilhafterweise über eine Kompensationsschaltung, die Schwankungen der Offsetspannung OF minimieren. Die Signale werden vorteilhafterweise mit einem A/D-Wandler digitalisiert und in einer Auswerteeinheit, die aus einem Mikrocontroller oder Mikroprozessor bestehen kann, bearbeitet.

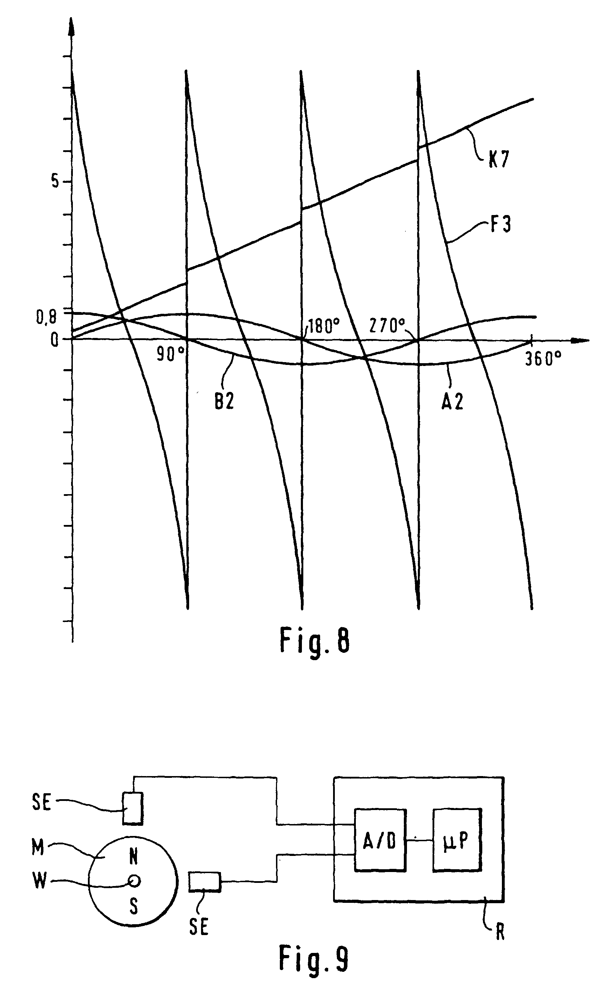

Als Amplitude der normierten Spannung verwendet man vorteilhafterweise die minimale auftretende Amplitude der Signale für Sinus 90° bzw. Cosinus 0°. Die sich daraus ergebenden Vorteile werden später insbesondere anhand der Figur 8 näher erläutert werden.

Man wählt vorteilhafterweise einen Kurvenverlauf nach Figur 3, bei dem der Mittelwert der Signale gleich 0 ist. In Figur 3 ist der Maximalwert der Amplitude der Signale = plus 1. Der Minimalwert der Amplitude entsprechend minus 1. Somit ergibt sich eine Amplitudendifferenz AD zwischen dem Wert der normierten Maximal- und Minimalamplitude von 2.

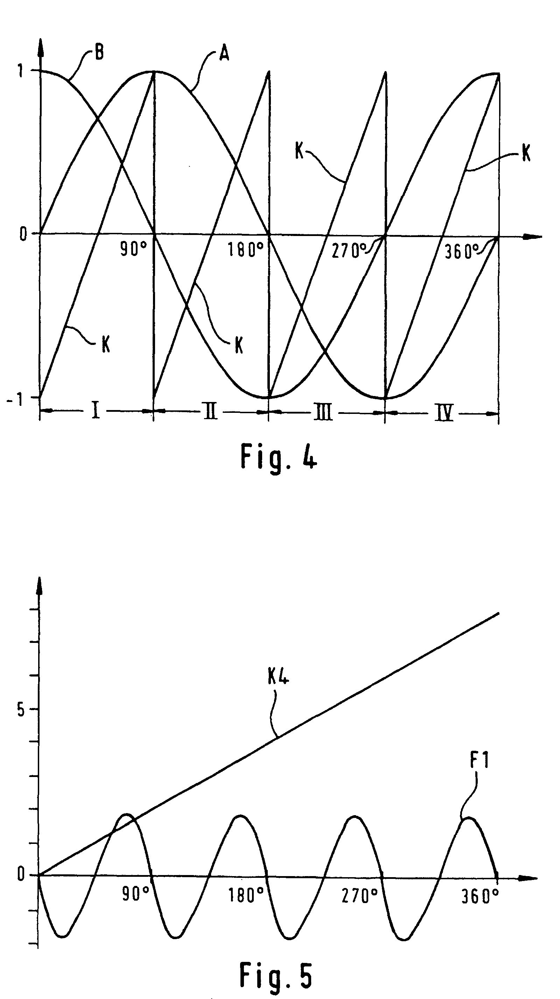

In Figur 4 sind die Vorzeichenveränderungen der Werte WA, WB der Sinuskurve A und der Cosinuskurve B in den vier Quadranten I bis IV erkennbar. Die Sinuskurve A weist im zweiten und dritten Quadranten II, III eine negative Steigung auf. Deshalb wird das Vorzeichen eines gemessenen Funktionswertes WA in diesen Quadranten verändert. Die Cosinuskurve B weist im ersten und zweiten Quadranten I, II eine negative Steigung auf, deshalb wird ein Vorzeichen eines gemessenen Funktionswertes WB im ersten und zweiten Quadranten I, II verändert. Insgesamt gelten für die Funktionswerte WA, WB die folgenden veränderten Funktionswerte WAV, WBV:

| Im ersten Quadranten | WAV = + WA | WBV = - WB |
|---|---|---|
| Im zweiten Quadranten | WAV = - WA | WBV = - WB |
| Im dritten Quadranten | WAV = - WA | WBV = + WB |
| Im vierten Quadranten | WAV = + WA | WBV = + WB |

Die erste Summe wird gebildet aus der Summe der angepaßten Funktionswerte WAV, WBV der jeweiligen Funktionswerte WA, WB, die bei einem zu bestimmenden Winkel $\alpha$ gemessen werden. Die erste Summe entspricht der Winkeldifferenz $\beta$ zwischen der Mitte des jeweiligen Quadranten (45°, 135°, 225°, 315°) und dem gemessenen Winkel $\alpha$, wobei der Wert der Amplitudendifferenz AD zwischen der normierten Maximalamplitude (+1) und der normierten Minimalamplitude (-1) einem Wert von 90° entspricht. Es gilt also für die Werte aus den Beispielen in Figur 3:

$$\beta = \frac{S \times 90°}{AD} = \frac{S \times 90°}{2} = S \times 45°$$

Um zum gesuchten Winkel $\alpha$ zu gelangen, muß noch der Winkel $\delta$, der zwischen 0° und der Mitte des Quadranten, in dem sich der gesuchte Winkel $\alpha$ befindet, zu dem Winkel $\beta$ addiert werden.

In Figur 4 ist weiterhin die dritte Kurve K dargestellt. Die Kurve K beginnt bei -1 zu Beginn eines jeden Quadranten, hat in der Mitte des jeweiligen Quadranten den Wert 0 und steigt bis zum Ende des jeweiligen Quadranten auf den Wert 1. Die dritte Kurve K ist entweder zwischen dem Anfang und dem Ende eines Quadranten eine Strecke, oder aber sie wird durch die Summe der jeweiligen Sinus- und Cosinuswerte der entsprechenden Winkel erhalten, wobei die Vorzeichen der jeweiligen Funktionswerte WA, WB dann verändert werden, wenn die jeweilige Funktion eine negative Steigung aufweist.

Versieht man die dritte Kurve K in jedem Quadranten mit einem jeweiligen bestimmten Offset, so erhält man die in Figur 5 dargestellte vierte Kurve K 4, die von 0 zu Beginn des ersten Quadranten bis 8 (dem vierfachen Wert der Amplitudendifferenz AD zwischen der normierten maximalen (plus 1) und minimalen (-1) Amplitude) reicht. In Figur 5 ist weiterhin der Fehler F 1 in Grad dargestellt, der dadurch entsteht, daß für die Feststellung des gesuchten Winkels $\alpha$ die Gleichung 1 verwendet wird, anstelle des Ablesens des Winkels an einer dritten Kurve K, die durch Addition der den Winkeln entsprechenden Sinus- und Cosinuswerte, deren Vorzeichen entsprechend angepaßt wurde, erhalten wird. Somit tritt bei Verwendung von Gleichung 1 ein systembedingter Fehler F1 von bis zu +/-2° gegenüber dem tatsächlichen Winkel auf, wenn die gemessenen Sinus- und Cosinuskurven den normierten Werten entsprechen.

In Figur 6 sind die Verläufe zweier sinusförmigen Signale A1, B1 nach der Normierung dargestellt, deren Amplitude vor der Begrenzung den 1,2 fachen Wert des normierten Signales hatten, wie durch die punktierten Kurvenstükke $A_0$ $B_0$ gezeigt.

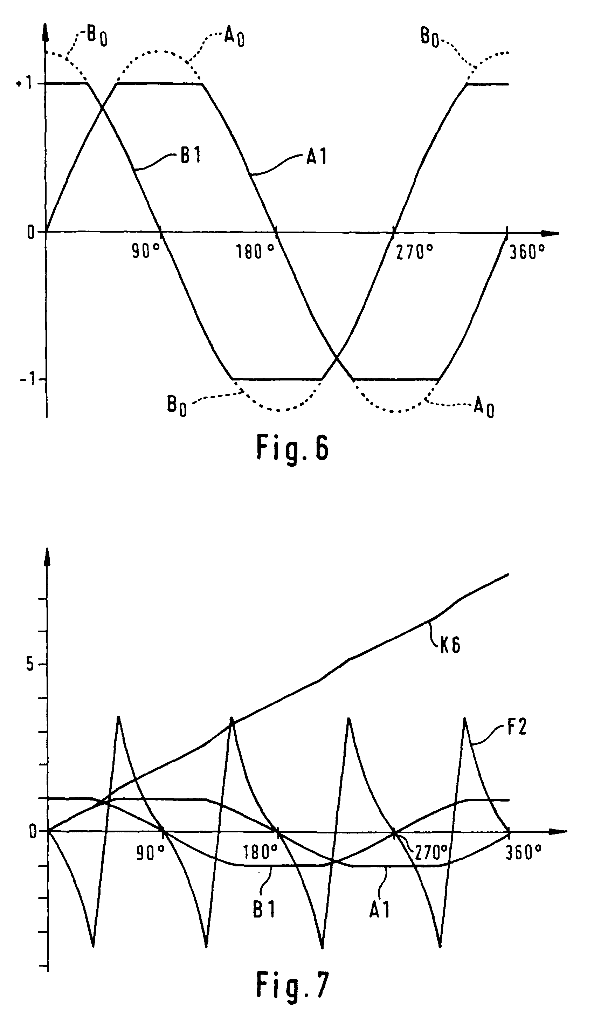

In Figur 7 sind die zwei Signale A1, B1 aus Figur 6 und die Kurve K6 dargestellt, die dadurch erhalten wird, daß für die Kurven A1, B1 mit angepaßtem Vorzeichen addiert und in jedem Quadranten mit einem derartigen Offset versehen werden, daß die Kurve stetig ist. Der Offset hat jeweils folgende Werte:

| Im ersten Quadranten | +0,5 AD |
|---|---|
| Im zweiten Quadranten | +1,5 AD |

(fortgesetzt)

| Im dritten Quadranten | +2,5 AD |
|---|---|
| Im vierten Quadranten | +3,5 AD. |

Der insgesamt durch die Verwendung von Gleichung 1 auftretende Fehler in Grad F2 ist ebenfalls dargestellt:

Man erkennt, daß er bei 45°,90°... gleich 0 ist und dazwischen bis auf 1° ansteigt. Wesentlich ist, daß keine Sprünge bei den Fehlern auftreten, so daß bei kleinen Winkeländerungen die gemessene Winkeldifferenz mit einem kleinen Fehler behaftet ist.

Werden die gemessenen Signale kleiner als das normierte Signal, wie z.B. in Figur 8, wo die Amplituden der gemessenen Signale A2, B2 nur 0,8 fachen Wert des normierten Signals aufweisen, so ergibt die Addition der beiden Kurven A, B mit entsprechend angepaßten Vorzeichen und einem Offset, wie bei der Kurve K6 in Figur 7 die Kurve K7:

Man erkennt Sprünge. Dies bedeutet für den dabei auftretenden Fehler F 3, daß er bei einem Vielfachen von 90° jeweils einen Sprung macht und dabei sein Vorzeichen ändert: So kann bei einer kleinen Winkeländerung der Welle, bspw. bei 89,5° auf 90,5° eine Winkeländerung von 4° berechnet werden, das Meßergebnis wird also für kleine Winkeländerungen unbrauchbar. Deshalb ist es vorteilhaft, den normierten Wert so auszuwählen, daß keine kleinere Amplitudendifferenz als die Amplitudendifferenz AD zwischen den normierten Maximal- und Minimalwerten auftreten kann, um das Verfahren auch bei zu messenden kleinen Winkeländerungen verwenden zu können.

In Figur 9 ist eine diametral magnetisierte Scheibe M dargestellt, die mit der Drehwelle W verbunden ist. Zwei Sensoren SE sind im gleichen radialen Abstand von der Drehwelle W und der Scheibe M um 90° versetzt angeordnet. Durch die Drehung entstehen sinusförmige Signale, die zwischen den Hallsensoren SE um 90°-phasenverschoben sind. Diese Werte werden in der Auswerteeinheit R mit dem zuvor beschriebenen Verfahren ausgewertet, wobei die Auswerteeinheit R einen A/D-Wandler und einen μ-Prozessor μP aufweist.

**Patentansprüche**

1. Verfahren zum Erfassen des Drehwinkels ($\alpha$) einer drehbaren Welle, bei dem durch das Drehen der Welle zwei sinusförmige Signale (A, B) erzeugt werden, die gegeneinander eine Phasenverschiebung von 90° aufweisen und vor der ersten Messung normiert werden, und bei dem die Signalwerte (WA, WB) der beiden Signale (A, B) bei dem gesuchten Drehwinkel ($\alpha$) gemessen werden; **dadurch gekennzeichnet**,

   a) **daß** die Signalwerte (WA, WB), die größer als der normierte Maximalwert bzw. kleiner als der normierte Minimalwert sind, auf die Maximal- bzw. Minimalwerte begrenzt werden,

   b) **daß** durch den Wert der gemessenen Signale der Quadrant (I, II, III, IV) bestimmt wird, in dem sich der gesuchte Winkel ($\alpha$) befindet,

   c) **daß** in Abhängigkeit des Vorzeichens der jeweiligen Kurvensteigung das Vorzeichen des Signalwertes (WA, WB) verändert oder beibehalten wird,

   d) **daß** die so erhaltenen angepaßten Signalwerte (WAV, WBV) zu einer ersten Summe S addiert werden,

   e) **daß** für die Winkeldifferenz ($\beta$) zwischen der Mitte des ermittelten Quadranten (I, II, III, IV) und dem gesuchten Winkel ($\alpha$) gilt:

   $$\beta = \frac{S}{AD} \times 90°$$

   wobei AD den Wert der Amplitudendifferenz zwischen dem normierten Maximal- und Minimalamplituden darstellt.

2. Verfahren nach Anspruch 1, **dadurch gekennzeichnet,**
   **daß** im Schritt c) bei negativer Kurvensteigung das Vorzeichen des jeweiligen Signalwertes (WA, WB) angepaßt wird,
   **daß** zur ersten Summe (S) der halbe Wert der Amplitudendifferenz (AD) addiert wird und so die zweite Summe (S2) erhalten wird,

**daß** für die Winkeldifferenz (γ) zwischen dem Beginn des festgestellten Quadranten (I, II, III, IV) und dem gesuchten Winkel (α) gilt:

$$\gamma = \frac{(S + \frac{1}{2}\, AD) \times 90°}{AD} = \frac{S2 \times 90°}{AD} = \beta + 45°$$

3. Verfahren nach Anspruch 2, **dadurch gekennzeichnet, daß**
eine dritte Summe (S3) gebildet wird aus der zweiten Summe (S2) und dem Produkt eines n-fachen der Amplitudendifferenz (AD) zwischen dem normierten Maximal- und Minimalwert, wobei n im ersten Quadrant (I) = 0, im zweiten Quadrant (II) = 1, im dritten Quadrant (III) = 2 und im vierten Quadrant (IV) = 3 ist,
**daß** für den gesuchten Winkel (α) gilt:

$$\alpha = \frac{S3}{4 \times AD} \times 90°$$

4. Verfahren zum Erfassen des Drehwinkels (α) einer drehbaren Welle, bei dem durch das Drehen der Welle zwei sinusförmige Signale (A, B) erzeugt werden, die gegeneinander eine Phasenverschiebung von 90° aufweisen und vor der ersten Messung normiert werden, und bei dem die Signalwerte (WA, WB) der beiden Signale (A, B) bei dem gesuchten Drehwinkel (α) gemessen werden, **dadurch gekennzeichnet,**

   a) **daß** die Signalwerte (WA, WB), die größer als der normierte Maximalwert bzw. kleiner als der normierte Minimalwert sind, auf die Maximal- bzw. Minimalwerte begrenzt werden,

   b) **daß** durch den Wert der gemessenen Signale der Quadrant (I, II, III, IV) bestimmt wird, in dem sich der gesuchte Winkel (α) befindet,

   c) **daß** in Abhängigkeit des Vorzeichens der jeweiligen Kurvensteigung das Vorzeichen des Signalwertes (WA, WB) verändert oder beibehalten wird,

   d) **daß** die so erhaltenen angepaßten Signalwerte (WAV, WBV) zu einer ersten Summe (S) addiert werden,

   **daß** eine dritte Kurve (K) gebildet wird, die darstellt entweder eine Gerade zwischen dem minimalen normierten Wert (-1) zu Beginn eines Quadranten (0°) und dem maximalen normierten Wert (+1) am Ende eines Quadranten, wenn im Schritt c) das Vorzeichen des Signalwertes (WA, WB) bei jeweils negativer Steigung der Kurve verändert wurde bzw. zwischen dem maximalen normierten Wert (+1) am Anfang des Quadranten (0°) und dem minimalen normierten Wert (-1) am Ende des Quadranten (90°) wenn im Schritt c) das Vorzeichen des Signalwertes (WA, WB) bei positiver Steigung der Kurve (K) angepaßt wurde
   oder eine Kurve (K), die dadurch erhalten wird, daß für eine bestimmte Anzahl von gegebenen Winkeln zugeordnet werden die jeweiligen (WA,WB) Summen der den Winkeln entsprechenden Sinus- und Cosinuswerte, wobei die Sinus- und Cosinuswerte die in Schritt c) angepaßten Vorzeichen aufweisen,
   daß der gesuchte Winkel dem Winkel entspricht, den die dritte Kurve (K) im jeweiligen Quadranten (I, II, III, IV) für den Wert der ersten Summe (S) aufweist.

5. Verfahren zum Erfassen des Drehwinkels (α) einer drehbaren Welle, bei dem durch das Drehen der Welle zwei sinusförmige Signale (A, B) erzeugt werden, die gegeneinander eine Phasenverschiebung von 90° aufweisen und vor der ersten Messung normiert werden, und bei dem die Signalwerte (WA, WB) der beiden Signale (A, B) bei dem gesuchten Drehwinkel (α) gemessen werden, **dadurch gekennzeichnet,**

   a) **daß** die Signalwerte (WA, WB), die größer als der normierte Maximalwert bzw. kleiner als der normierte Minimalwert sind, auf die Maximal- bzw. Minimalwerte begrenzt werden,

   b) **daß** durch den Wert der gemessenen Signale der Quadrant (I, II, III, IV) bestimmt wird, in dem sich der gesuchte Winkel (α) befindet,

   c) **daß** in Abhängigkeit des Vorzeichens der jeweiligen Kurvensteigung das Vorzeichen des Signalwertes (WA, WB) verändert oder beibehalten wird,

   d) **daß** die so erhaltenen angepaßten Signalwerte (WAV, WBV) zu einer ersten Summe (S) addiert werden,

**daß** die erste Summe (S) mit einer Winkeltabelle verglichen wird, wobei in der Winkeltabelle die jeweiligen Summen der Sinus- und Cosinuswerte der Winkel den entsprechenden Winkeln zugeordnet sind, wobei die Vorzeichen der Sinus- und Cosinuswerte entsprechend Schritt c) angepaßt sind.

6. Verfahren nach Anspruch 4, **dadurch gekennzeichnet, daß** im Schritt c) bei negativer Kurvensteigung das Vorzeichen des Signalwertes (WA, WB) verändert wird,
daß die Teile der dritten Kurve (K) in den einzelnen Quadranten (I, II, III, IV) so in Y-Richtung verschoben werden, daß sie eine stetige vierte Kurve bilden, die zu Beginn des ersten Quadranten (I) den Wert 0 und am Ende des vierten Quadranten (IV) den vierfachen Wert der Amplitudendifferenz (AD) zwischen der normierten Maximal- und Minimalamplitude aufweist,
**daß** die dritte Summe mit der vierten Kurve (K4, K6) verglichen wird,
**daß** der gesuchte Winkel ($\alpha$) dem Winkel entspricht, den die vierte Kurve für den Wert der dritten Summe (S3) aufweist.

7. Verfahren nach einem der vorstehenden Ansprüche, **dadurch gekennzeichnet, daß** die Werte der normierten Amplitude so gewählt werden, **daß** sie kleiner oder gleich sind der kleinsten Amplitude, die durch Schwankungen der Amplituden der sinusförmigen Kurven (A, B) auftreten können.

8. Vorrichtung zur Ausführung des Verfahrens nach einem der vorstehenden Ansprüche 1-3, die eine Einrichtung (M) aufweist, die ein sinusförmiges Signal erzeugt, die mit der Drehwelle (W) verbunden ist, deren Drehwinkel ($\alpha$) bestimmt werden soll, die weiterhin zwei Sensoren (SE) zum Messen von Signalen (A, B) aufweist, wobei die Sensoren (SE) in gleichem Abstand von der Drehwelle (W) um 90° versetzt angeordnet sind, und wobei die Signale (A,B) vor der ersten Messung normiert werden und bei der eine Auswerteeinrichtung (R) zum Bearbeiten von den Signalwerten (WA, WB) der Sensoren und zum Berechnen des gesuchten Drehwinkels ($\alpha$) vorhanden ist, **dadurch gekennzeichnet, daß** mit der Auswerteinichtung

a) die Signalwerte (WA, WB), die größer als der normierte Maximalwert bzw. kleiner als der normierte Minimalwert sind, auf die Maximal- bzw. Minimalwerte begrenzbar sind,

b) der Quadrant (I, II, III, IV) durch den Wert der gemessenen Signalwerte (WA, WB) bestimmbar ist, in dem sich der gesuchte Winkel ($\alpha$) befindet,

c) in Abhängigkeit des Vorzeichens der jeweiligen Kurvensteigung das Vorzeichen des Signalwertes (WA, WB) veränderbar oder beibehaltbar ist,

d) die so erhaltenen angepaßten Signalwerte (WAV, WBV) zu einer ersten Summe (S) addierbar sind,

e) die Winkeldifferenz ($\beta$) zwischen der Mitte des ermittelten Quadranten (I, II, III, IV) und dem gesuchten Winkel ($\alpha$) ermittelbar ist mit der folgenden Gleichung:

$$\beta = \frac{S}{AD} \times 90°$$

wobei AD den Wert der Amplitudendifferenz zwischen dem normierten Maximal- und Minimalamplituden darstellt.

9. Vorrichtung nach Anspruch 8, **dadurch gekennzeichnet, daß** die Einrichtung (M) eine diametral magnetisierte Scheibe ist.

10. Vorrichtung nach Anspruch 8 oder 9, **dadurch gekennzeichnet, daß** die Sensoren (SE) Hallsensoren sind.

11. Vorrichtung nach Anspruch 10, **dadurch gekennzeichnet, daß** die Hallsensoren (SE) selbstjustierend sind.

12. Vorrichtung nach einem der Ansprüche 8 bis 11, **dadurch gekennzeichnet, daß** die Drehwelle (W) Teil eines drehbaren Schalters ist.

13. Vorrichtung nach Anspruch 12, **dadurch gekennzeichnet, daß** mit der Einrichtung (M) und mit zwei Spulen (SP1, SP2) ein Drehmoment erzeugbar ist.

**Claims**

1. Method for detecting the angle of rotation ($\alpha$) of a rotatable shaft, in the case of which the rotation of the shaft generates two sinusoidal signals (A, B) which have a mutual phase shift of 90° and are normalized before the first measurement, and in the case of which the signal values (WA, WB) of the two signals (A, B) are measured at the sought angle of rotation ($\alpha$),
**characterized**

    a) **in that** the signal values (WA, WB) which are greater than the normalized maximum value or smaller than the normalized minimized value are limited to the maximum and minimum values, respectively,
b) **in that** the value of the measured signals is used to determine the quadrant (I, II, III, IV) in which the sought angle ($\alpha$) is located,
c) **in that** the sign of the signal value (WA, WB) is varied or retained as a function of the sign of the respective curve gradient,
d) **in that** the adapted signal values (WAV, WBV) thus obtained are added to form a first sum S, and
e) **in that** it holds for the angular difference ($\beta$) between the average of the determined quadrants (I, II, III, IV) and the sought angle ($\alpha$) that:

$$\beta = \frac{S}{AD} \times 90°,$$

AD representing the value of the amplitude difference between the normalized maximum and minimum amplitudes.

2. Method according to Claim 1, **characterized**
**in that** in step c) the sign of the respective signal value (WA, WB) is adapted in the event of a negative curve gradient,
**in that** the half value of the amplitude difference (AD) is added to the first sum (S), and the second sum (S2) is thus obtained, and
**in that** it holds for the angular difference ($\gamma$) between the beginning of the determined quadrants (I, II, III, IV) and the sought angle ($\alpha$) that:

$$\gamma = \frac{(S + \frac{1}{2}AD) \times 90°}{AD} = \frac{S2 \times 90°}{AD} = \beta + 45°$$

3. The method as claimed in Claim 2, **characterized**
**in that** a third sum (S3) is formed from the second sum (S2) and the product of an n-tuple of the amplitude difference (AD) between the normalized maximum and minimum values, n being = 0 in the first quadrant (I), = 1 in the second quadrant (II), = 2 in the third quadrant (III) and = 3 in the fourth quadrant (IV), and
**in that** it holds for the sought angle ($\alpha$) that:

$$\alpha = \frac{S3}{4 \times 90°} \times 90°.$$

4. Method for detecting the angle of rotation ($\alpha$) of a rotatable shaft, in the case of which the rotation of the shaft generates two sinusoidal signals (A, B) which have a mutual phase shift of 90° and are normalized before the first measurement, and in the case of which the signal values (WA, WB) of the two signals (A, B) are measured at the sought angle of rotation ($\alpha$),
**characterized**

    a) **in that** the signal values (WA, WB) which are greater than the normalized maximum value or smaller than the normalized minimized value are limited to the maximum and minimum values, respectively,
b) **in that** the value of the measured signals is used to determine the quadrant (I, II, III, IV) in which the sought angle ($\alpha$) is located,
c) **in that** the sign of the signal value (WA, WB) is varied or retained as a function of the sign of the respective curve gradient,
d) **in that** the adapted signal values (WAV, WBV) thus obtained are added to form a first sum S,

**in that** a third curve (K) is formed which constitutes either a straight line between the minimum normalized value (-1) at the beginning of a quadrant (0°) and the maximum normalized value (+1) at the end of a quadrant, if in step c) the sign of the signal value (WA, WB) was varied in the event of a respectively negative gradient of the curve, or between the maximum normalized value (+1) at the start of the quadrant (0°) and the minimum normalized value (-1) at the end of the quadrant (90°) if in step c) the sign of the signal value (WA, WB) was adapted in the event of a positive gradient of the curve (K), or a curve (K) which is obtained by virtue of the fact that the respective (WA, WB) sums of the sinusoidal and cosinusoidal values corresponding to the angles are assigned for a specific number of given angles, the sinusoidal and cosinusoidal values having the signs adapted in step c), and

**in that** the sought angle corresponds to the angle which the third curve (K) has in the respective quadrant (I, II, III, IV) for the value of the first sum (S).

5. Method for detecting the angle of rotation ($\alpha$) of a rotatable shaft, in the case of which the rotation of the shaft generates two sinusoidal signals (A, B) which have a mutual phase shift of 90° and are normalized before the first measurement, and in the case of which the signal values (WA, WB) of the two signals (A, B) are measured at the sought angle of rotation ($\alpha$),

   **characterized**

   a) **in that** the signal values (WA, WB) which are greater than the normalized maximum value or smaller than the normalized minimized value are limited to the maximum and minimum values, respectively,
   b) **in that** the value of the measured signals is used to determine the quadrant (I, II, III, IV) in which the sought angle ($\alpha$) is located,
   c) **in that** the sign of the signal value (WA, WB) is varied or retained as a function of the sign of the respective curve gradient,
   d) **in that** the adapted signal values (WAV, WBV) thus obtained are added to form a first sum S, and

   **in that** the first sum (S) is compared with an angle table, the respective sums of the sinusoidal and cosinusoidal values of the angles being assigned in the angle table to the corresponding angles, the signs of the sinusoidal and cosinusoidal values being adapted in accordance with step c).

6. Method according to Claim 4, **characterized in that** the sign of the signal value (WA, WB) is varied in step c) in the event of a negative curve gradient,
   **in that** the parts of the third curve (K) in the individual quadrants (I, II, III, IV) are displaced in the Y direction such that they form a continuous fourth curve which has the value 0 at the start of the first quadrant (I), and the fourfold value of the amplitude difference AD) between the normalized maximum and minimum amplitudes at the end of the fourth quadrant (IV),
   **in that** the third sum is compared with the fourth curve (K4, K6), and
   **in that** the sought angle ($\alpha$) corresponds to the angle which the fourth curve has for the value of the third sum (S3).

7. Method according to one of the preceding claims, **characterized in that** the values of the normalized amplitude are selected such that they are smaller than or equal to the smallest amplitude which can occur owing to fluctuations in the amplitudes of the sinusoidal curves (A, B).

8. Apparatus for carrying out the method according to one of the preceding Claims 1-3, which has a device (M) which generates a sinusoidal signal which is connected to the rotary shaft (W) whose angle of rotation ($\alpha$) is to be determined, which further has two sensors (SE) for measuring signals (A, B), the sensors (SE) being arranged offset by 90° at the same distance from the rotary shaft (W), and the signals (A, B) being normalized before the first measurement and in the case of which an evaluation device (R) is present for processing signal values (WA, WB) of the sensors and for calculating the sought angle of rotation ($\alpha$), **characterized in that** with the aid of the evaluation device

   a) the signal values (WA, WB) which are greater than the normalized maximum value or smaller than the normalized minimum value can be limited to the maximum or minimum values, respectively,
   b) the quadrant (I, II, III, IV) can be determined by using the value of the measured signal values (WA, WB) in which the sought angle ($\alpha$) is located,
   c) the sign of the signal value (WA, WB) can be varied or retained as a function of the sign of the respective curve gradient,
   d) the adapted signal values (WAV, WBV) thus obtained can be added to form a first sum (S), and

e) the angular difference (β) between the average of the determined quadrants (I, II, III, IV) and the sought angle (α) can be determined with the aid of the following equation:

$$\beta = \frac{S}{AD} \times 90°$$

AD representing the value of the amplitude difference between the normalized maximum and minimum amplitudes.

**9.** Apparatus according to Claim 8, **characterized in that** the device (M) is a diametrically magnetized disk.

**10.** Apparatus according to Claim 8 or 9, **characterized in that** the sensors (SE) are Hall sensors.

**11.** Apparatus according to Claim 10, **characterized in that** the Hall sensors (SE) are self adjusting.

**12.** Apparatus according to one of Claims 8 to 11, **characterized in that** the rotary shaft (W) is part of a rotatable switch.

**13.** Apparatus according to Claim 12, **characterized in that** a torque can be generated with the aid of device (M) and of two coils (SP1, SP2).


**Revendications**

**1.** Procédé permettant de relever l'angle de rotation (α) d'un arbre rotatif, selon lequel, du fait de la rotation de l'arbre, il est produit deux signaux sinusoïdaux (A, B) qui présentent un déphasage de 90° l'un vis-à-vis de l'autre 30 et sont normalisés avant la première mesure, et selon lequel les valeurs de signal (WA, WB) des deux signaux (A, B) sont mesurées pour l'angle de rotation (α) recherché, **caractérisé**

a) en ce que les valeurs de signal (WA, WB) qui sont supérieures à la valeur maximale normalisée ou inférieures à la valeur minimale normalisée sont limitées aux valeurs respectivement maximale ou minimale,
b) en ce que, au moyen de la valeur des signaux mesurés, le quadrant (I, II, III, IV) dans lequel l'angle (α) recherché se trouve est déterminé,
c) en ce que, en fonction du signe de l'inclinaison de courbe chaque fois considérée, le signe de la valeur de signal (WA, WB) est changé ou maintenu,
d) en ce que les valeurs de signal adaptées (WAV, WBV) ainsi obtenues sont ajoutées pour donner une première somme S,
e) en ce que, pour la différence d'angle (β) entre le milieu du quadrant (I, II, III, IV) déterminé et l'angle (α) recherché, il vient :

$$\beta = \frac{S}{AD} \, x \, 90°$$

AD représentant la valeur de la différence d'amplitude entre les amplitudes maximale et minimale normalisées.

**2.** Procédé suivant la revendication 1, **caractérisé**
**en ce que**, dans l'étape c), en cas d'inclinaison de courbe négative, le signe de la valeur de signal (WA, WB) chaque fois considérée est adapté,
**en ce que**, pour la première somme (S), la demi-valeur de la différence d'amplitude (AD) est ajoutée et la seconde somme (S2) est ainsi obtenue,
**en ce que**, pour la différence d'angle (γ) entre le début du quadrant (I, II, III, IV) déterminé et l'angle (α) recherché, il vient :

$$\gamma = \frac{(S + 1/2AD) \, x \, 90°}{AD} = \frac{S2 \, x \, 90°}{AD} = \beta + 45°.$$

**3.** Procédé suivant la revendication 2, **caractérisé en ce que**
une troisième somme (S3) est formée à partir de la deuxième somme (S2) et du produit d'un multiple énième de la différence d'amplitude (AD) entre les valeurs maximale et minimale normalisées, n étant = 0 dans le premier quadrant (I), = 1 dans le deuxième quadrant (II), = 2 dans le troisième quadrant (III) et = 3 dans le quatrième quadrant (IV),

**en ce que**, pour l'angle ($\alpha$) recherché, il vient :

$$\alpha = \frac{S3}{4 \; x \; AD} \; x \; 90°.$$

4. Procédé permettant de relever l'angle de rotation ($\alpha$) d'un arbre rotatif, selon lequel, du fait de la rotation de l'arbre, il est produit deux signaux sinusoïdaux (A, B) qui présentent un déphasage de 90° l'un vis-à-vis de l'autre 30 et sont normalisés avant la première mesure, et selon lequel les valeurs de signal (WA, WB) des deux signaux (A, B) sont mesurées pour l'angle de rotation ($\alpha$) recherché, **caractérisé**

a) **en ce que** les valeurs de signal (WA, WB) qui sont supérieures à la valeur maximale normalisée ou inférieures à la valeur minimale normalisée sont limitées aux valeurs respectivement maximale ou minimale,
b) **en ce que**, au moyen de la valeur des signaux mesurés, le quadrant (I, II, III, IV) dans lequel l'angle ($\alpha$) recherché se trouve est déterminé,
c) **en ce que**, en fonction du signe de l'inclinaison de courbe chaque fois considérée, le signe de la valeur de signal (WA, WB) est changé ou maintenu,
d) **en ce que** les valeurs de signal adaptées (WAV, WBV) ainsi obtenues sont ajoutées pour donner une première somme S,

**en ce qu'**est formé une troisième courbe (K) qui représente

soit une droite entre la valeur normalisée minimale (- 1) au début d'un quadrant (0°) et la valeur normalisée maximale (+ 1) à la fin d'un quadrant lorsqu'à l'étape c), le signe de la valeur de signal (WA, WB) a été changé lors d'une inclinaison négative respective de la courbe ou entre la valeur normalisée maximale (+ 1) au début du quadrant (0°) et la valeur normalisée minimale (- 1) à la fin du quadrant (90°) lorsqu'à l'étape c), le signe de la valeur de signal (WA, WB) a été adapté lors d'une inclinaison positive de la courbe (K),

soit une courbe (K) qui est obtenue par le fait que, pour un nombre déterminé d'angles donnés, les sommes (WA, WB) respectives des valeurs de sinus et de cosinus correspondant aux angles sont associées, les valeurs de sinus et de cosinus présentant les signes adaptés à l'étape c),

**en ce que** l'angle recherché correspond à l'angle que la troisième courbe (K) dans le quadrant (I, II, III, IV) considéré présente pour la valeur de la première somme (S).

5. Procédé permettant de relever l'angle de rotation ($\alpha$) d'un arbre rotatif, selon lequel, du fait de la rotation de l'arbre, il est produit deux signaux sinusoïdaux (A, B) qui présentent un déphasage de 90° l'un vis-à-vis de l'autre et sont normalisés avant la première mesure, et selon lequel les valeurs de signal (WA, WB) des deux signaux (A, B) sont mesurées pour l'angle de rotation ($\alpha$) recherché, **caractérisé**

a) **en ce que** les valeurs de signal (WA, WB) qui sont supérieures à la valeur maximale normalisée ou inférieures à la valeur minimale normalisée sont limitées aux valeurs respectivement maximale ou minimale,
b) **en ce que**, au moyen de la valeur des signaux mesurés, le quadrant (I, II, III, IV) dans lequel l'angle ($\alpha$) recherché se trouve est déterminé,
c) **en ce que**, en fonction du signe de l'inclinaison de courbe chaque fois considérée, le signe de la valeur de signal (WA, WB) est changé ou maintenu,
d) **en ce que** les valeurs de signal adaptées (WAV, WBV) ainsi obtenues sont ajoutées pour donner une première somme S,

**en ce que** la première somme (S) est comparée à une table d'angles, les sommes respectives des valeurs de sinus et de cosinus des angles étant associées, dans la table d'angles, aux angles correspondants, tandis que les signes des valeurs de sinus et de cosinus sont adaptés conformément à l'étape c).

6. Procédé suivant la revendication 4, **caractérisé en ce qu'**à l'étape c), pour une inclinaison de courbe négative, le signe de la valeur de signal (WA, WB) est changé,

**en ce que** les parties de la troisièmes courbe (K) situées dans les différents quadrants (I, II, III, IV) sont déplacées suivant la direction Y de manière à former une quatrième courbe continue qui présenté au début du premier quadrant (I) la valeur 0 et à la fin du quatrième quadrant (IV) la valeur quadruple de la différence d'amplitude (AD) entre les amplitudes maximale et minimale normalisées,

**en ce que** la troisième somme est comparée à la quatrième courbe (K4, K6),
**en ce que** l'angle (α) recherché correspond à l'angle que la quatrième courbe présente pour la valeur de la troisième somme (S3).

7. Procédé suivant l'une des revendications précédentes, **caractérisé en ce que** les valeurs des amplitudes normalisées sont choisies de manière à être inférieures ou égales à la plus petite amplitude qui peuvent se présenter du fait de fluctuations des amplitudes des courbes sinusoïdales (A, B).

8. Dispositif de mise en oeuvre du procédé suivant l'une des revendications précédentes 1 - 3, comprenant un dispositif (M) qui produit un signal sinusoïdal et est relié à l'arbre rotatif (W) dont l'angle de rotation (α) doit être déterminé, ce dispositif comprenant en outre deux capteurs (SE) servant à la mesure de signaux (A, B), les capteurs (SE) étant disposés à la même distance de l'arbre rotatif (W) en étant décalés de 90°, les signaux (A, B) étant normalisés avant la première mesure, et dans lequel il est prévu un dispositif d'analyse (R) servant à traiter les valeurs de signal (WA, WB) des capteurs et à calculer l'angle de rotation (α) recherché, **caractérisé en ce que**, au moyen du dispositif d'analyse,

a) les valeurs de signal (WA, WB) qui sont supérieures à la valeur maximale normalisée ou inférieures à la valeur minimale normalisée peuvent être limitées aux valeurs maximales ou minimales,
b) le quadrant (I, II, III, IV) dans lequel l'angle (α) recherché se trouve peut être déterminé au moyen de la grandeur des valeurs de signal (WA, WB) mesurées,
c) en fonction du signe de l'inclinaison de courbe chaque fois considérée, le signe de la valeur de signal (WA, WB) peut être changé ou peut être maintenu,
d) les valeurs de signal adaptées (WAV, WBV) ainsi obtenues peuvent être ajoutées pour donner une première somme (S),
e) la différence d'angle (β) entre le milieu du quadrant (I, II, III, IV) déterminé et l'angle (α) recherché peut être déterminée par l'équation suivante :

$$\beta = \frac{S}{AD} \; x \; 90°$$

AD représentant la valeur de la différence d'amplitude entre les amplitudes maximale et minimale normalisées.

9. Dispositif suivant la revendication 8, **caractérisé en ce que** le dispositif (M) est un disque aimanté diamétralement.

10. Dispositif suivant la revendication 8 ou 9, **caractérisé en ce que** les capteurs (SE) sont des capteurs Hall.

11. Dispositif suivant la revendication 10, **caractérisé en ce que** les capteurs Hall (SE) sont à auto-ajustement.

12. Dispositif suivant l'une des revendications 8 à 11, **caractérisé en ce que** l'arbre rotatif (W) fait partie d'un interrupteur rotatif.

13. Dispositif suivant la revendication 12, **caractérisé en ce qu'**au moyen du dispositif (M) et de deux bobines (SP1, SP2), un couple peut être produit.

EP 0 877 488 B1

Fig. 1

Fig. 2

Fig. 3

Fig. 4

Fig. 5

Fig. 6

Fig. 7

Fig. 8

Fig. 9